# EUROPÄISCHE PATENTSCHRIFT

(11) **EP 1 680 864 B1**
(45) Veröffentlichungstag und Bekanntmachung des Hinweises auf die Patenterteilung: **10.09.2008**
(21) Anmeldenummer: 04797541.2
(22) Anmeldetag: 03.11.2004
(51) Int. Cl.: H03K 17/96, H05B 3/74, G06F 3/033

(54) **BEDIENEINRICHTUNG**
OPERATING DEVICE
DISPOSITIF DE COMMANDE

(30) Priorität: 05.11.2003 DE 10352714
(43) Veröffentlichungstag der Anmeldung: 19.07.2006
(73) Patentinhaber: E.G.O. ELEKTRO-GERÄTEBAU GmbH, D-75038 Oberderdingen (DE)
(72) Erfinder: MARTIN, Baier, 76275 Ettlingen (DE)
(74) Vertreter: Patentanwälte Ruff, Wilhelm, Beier, Dauster & Partner
(86) Internationale Anmeldenummer: PCT/EP2004/012400
(87) Internationale Veröffentlichungsnummer: WO 2005/046057

(56) Entgegenhaltungen:
- EP-A- 0 446 642
- DE-C1- 4 041 144
- US-A- 4 567 480
- US-A1- 2001 020 578

## Beschreibung

Die Erfindung betrifft eine Bedieneinrichtung zur Bedienung beispielsweise eines Elektrogeräts, welches z.B. ein Haushaltsgerät wie ein Kochfeld oder dergleichen sein kann, oder allgemein zur Bedienung einer Vorrichtung.

Derartige Vorrichtungen oder Bedieneinrichtungen weisen teilweise Sieben-Segment-Anzeigen auf sowie, für den Bedienungsvorgang, sogenannte Berührungsschalter. Eine solche Bedieneinrichtung ist beispielsweise aus der EP 1 030 536 A1 bekannt. Der Berührschatter ist hier als kapazitiver Berührschalter ausgebildet. Es ist des weiteren auch bekannt, ähnliche Berührschalter als sogenannte Reflex-Lichtschranke auszubilden mit einer Lichtquelle und einem Lichtempfänger. Dies geht beispielsweise aus der DE 197 00 838 C1 hervor.

Die EP 446 642 A1 beschreibt eine Lichtschrankenanordnung unter einem Glaskeramik-Kochfeld mit einem Lichtsender und einem Lichtempfänger. Dadurch wird eine Reflex-Lichtschranke gebildet und eine Strahlenweg von dem Lichtsender durch das Glaskeramik-Kochfeld hindurch wird durch einen oben aufgelegten Finger reflektiert zum Lichtempfänger. Dies wird als Betätigung ausgewertet. Neben dieser Reflex-Lichtschranke und getrennt davon ist eine Sieben-Segment-Anzeige in einem Gehäuse angeordnet.

Die DE 40 41 144 C1 zeigt allgemein eine Reflex-Lichtschranke mit Lichtsender und Lichtempfänger ähnlich der zuvor genannten Lichtschrankenanordnung. Die Reflex-Lichtschranke kann in einem Bereich unter einer Anzeigenoberfläche angeordnet werden. Die Anzeigenoberfläche ist eine Flüssigkristallanzeige, durch welche an jeder beliebigen Stelle das Infrarotlicht der Reflex-Lichtschranke hindurchtreten kann.

Die US 20011020578 A1 zeigt eine ähnliche Flüssigkristallanzeige mit einer Reflex-Lichtschranke, gebildet aus Lichtsender und Lichtempfänger. Lichtsender und Lichtempfänger sind so angeordnet, dass der Strahlenweg durch ein von der Anzeigenoberfläche dargestelltes Symbol hindurch läuft, wobei auch hier die Flüssigkristallanzeige für das Licht durchlässig ist.

### Aufgabe und Lösung

Der Erfindung liegt die Aufgabe zugrunde, eine eingangs genannte Bedieneinrichtung zu schaffen, mit der Nachteile des Standes der Technik vermieden werden können und insbesondere die Kombination einer Sieben-Segment-Anzeige mit einer Reflex-Lichtschranke vorteilhaft und praxistauglich ausgebildet werden kann.

Gelöst wird diese Aufgabe durch eine Bedieneinrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß ist vorgesehen, dass die Sieben-Segment-Anzeige einen Betriebszustand oder Anweisungen an einen Bediener anzeigt. Die Reflex-Lichtschranke als Berührschalter weist eine Lichtquelle und einen Lichtempfänger auf, wobei das Licht zwischen Lichtquelle und Lichtempfänger einen bestimmten Strahlenweg entlang läuft. Dabei sind Lichtquelle und Lichtempfänger derart angeordnet, dass der Strahlenweg mindestens einmal mitten durch die Sieben-Segment-Anzeige bzw. durch von deren Segmente gebildete Bereiche geht, die im wesentlichen umlaufend geschlossen sind. Dies bedeutet zum einen, dass die Lichtschranke sozusagen mitten in oder unter der Sieben-Segment-Anzeige angeordnet ist. Dies spart Platz, da üblicherweise Anzeigen und Lichtschranken nebeneinander und somit mit gewisser Breite angeordnet sind. Des weiteren ist hierdurch eine erhebliche einfachere und instinktivere Bedienung möglich, da ein Bediener lediglich direkt auf die Anzeige oder die durch die Anzeige erzeugte Erscheinung einen Finger legen kann zur Durchführung der gewünschten Bedienung. Dadurch können ansonsten üblicherweise verwendete Dekors entfallen, was Aufwand spart. Es werden auch die Bedienungssicherheit und der Bedienungskomfort erhöht, da bei manchen Dekors an der Oberseite der Berührfläche nicht immer eindeutig erkennbar ist, an welcher Stelle genau die Berührung stattfinden muss zur Auslösung des Berührschalters.

Zusätzlich können so beispielsweise Bedieneinrichtungen mit Berührschaltern geschaffen werden, welche bei ansonsten schlechten Lichtverhältnissen sehr gut bedient werden können. Es sind keine separaten Anzeigen oder Leuchtmittel erforderlich, um die Berührfläche zu markieren.

Um die Integration von Lichtschranke und Anzeige und somit den Platzbedarf noch weiter zu verbessern, kann vorteilhaft vorgesehen sein, dass für eine Reflex-Lichtschranke der Strahlenweg sowohl von der Lichtquelle weg als auch zum Lichtempfänger hin jeweils einmal durch einen im wesentlichen geschlossenen Kanal oder durch die Sieben-Segment-Anzeige geht. Bei der üblichen und bekannten Ausbildung solcher Anzeigen ist es in weiterer Ausgestaltung der Erfindung ebenfalls vorteilhaft möglich, die beiden Strahlenwege dadurch zu trennen, dass der eine Strahlenweg durch den einen geschlossenen Ring von Segmenten und der andere Strahlenweg durch den anderen geschlossenen Ring verläuft.

Des weiteren ist es von Vorteil, wenn hinsichtlich einer Abwägung zwischen Funktionalität und Platzbedarf mindestens der Strahlenweg zum Lichtempfänger hin durch die Sieben-Segment-Anzeige verläuft. So ist auf alle Fälle zumindest hier die Entfernung zwischen Berührfläche, Sieben-Segment-Anzeige und Strahlenweg zum auslösenden Lichtempfänger möglichst gering.

Es ist möglich, dass der Strahlenweg, insbesondere auch durch die Anzeige, möglichst abgeschirmt ist, beispielsweise in einem geschlossenen Kanal verläuft. Es sollte gewährleistet werden, dass sich das Licht der Lichtschranke sowie dasjenige der Anzeige nicht gegenseitig stört. Dies kann entweder durch Trennung mittels abgeschirmter Kanäle erfolgen, was jedoch aufwendig ist. Alternativ können Sieben-Segment-Anzeige und Lichtquelle im Wechsel, sozusagen im Multiplex-Betrieb, betrieben werden. Die Wechselfrequenz sollte so gewählt werden, dass der Wechsel für das menschliche Auge nicht sichtbar ist und trotzdem bedie Funktionen gewährleistet sind.

Ein Strahlenweg verläuft vorteilhaft durch den Zwischenraum zwischen vier LED-Elementen oder allgemein Leuchtelementen in einem Bereich der Anzeige. Diese Elemente bilden eine geschlossene, ringähnliche Anordnung in mehreckiger bzw. viereckiger oder parallelogrammartiger Form. Es kann hier vernachlässigt werden, dass sich in der Praxis die Elemente an den Enden nicht vollständig berühren, so dass sie immer noch als geschlossen im Sinne der Erfindung anzusehen sind.

Vorteilhaft ist eine Sieben-Segment-Anzeige als eine Baueinheit ausgebildet. Dies bedeutet, dass zumindest die Leuchtmittel oder LED, welche die einzelnen Segmente der Anzeige bilden, in einer Baueinheit bzw. als ein einziges Bauteil gegeben sind. In weiterer Ausgestaltung der Erfindung kann vorgesehen sein, dass Lichtquelle und/oder Lichtempfänger in die Anzeige bzw. in die Baueinheit mit der Anzeige integriert sind. Dies ermöglicht zum einen eine vereinfachte Montage, da weniger Bauteile zu montieren sind. Vor allem aber liegt ein großer Vorteil darin, dass Justierarbeiten, insbesondere hinsichtlich des Verlaufs des Strahlenweges des Lichts, entfallen können. Vor allem ist dies dann vorteilhaft, wenn in einer einzigen Baueinheit die Sieben-Segment-Anzeige und Lichtempfänger und Lichtquelle enthalten sind und, entsprechend wie bei normalen Bauteilen, abstehende Anschlüsse aufweisen. Diese können beispielsweise auf einer Leiterplatte angelötet werden. Die Anschlüsse können sowohl für Through-Hole-Techologie als auch für SMD-Technik ausgelegt sein.

Des weiteren kann bei einer Bedieneinrichtung vorgesehen sein, dass sie sowie weitere Bedieneinrichtungen oder weitere Anzeigen auf einer gemeinsamen Platine oder Leiterplatte angeordnet sind. Dies wird besonders dadurch vorteilhaft ermöglicht, dass durch den Verlauf des Strahlenwegs durch die Anzeige hindurch automatisch eine Abschirmung und Trennung gegenüber anderen Bauteilen, insbesondere leuchtenden Bauteilen, auf der gemeinsamen Platine gegeben ist.

Anstelle einer hochintegrierten Lösung mit einer einzigen Baueinheit ist es auch möglich, Lichtquelle und/oder Lichtempfänger, vorteilhaft beide zusammen, nicht in einem solchen Anzeigeelement, sondern darunter und separat davon anzuordnen. So ist es beispielsweise möglich, für eine Bedieneinrichtung mit mehreren Sieben-Segment-Anzeigen stets denselben Typ von Anzeige zu verwendet, selbst wenn nur eine oder wenige davon mit zugeordneten Berührschaltern versehen sein sollen. Vorteilhaft sind dann die Anzeigen in eigenen Baueinheiten enthalten, in welchen Durchbrüche oder oben beschriebene Kanäle vorgesehen sind. ' Auf ähnliche Weise ist es ebenfalls als im Rahmen der Erfindung liegend möglich, anstelle von Lichtschranken mit Lichtquelle und Lichtempfänger ähnliche Prinzipien für einen Berührschalter einzusetzen,.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: einen seitlichen Schnitt durch eine erfindungsgemäße Bedieneinrichtung unter einer Abdeckung,
- Fig. 2: eine alternative Ausführung von Fig. 1,
- Fig. 3: eine Draufsicht auf die Sieben-Segment-Anzeige gemäß Fig. 1 unterhalb der Abdeckung und
- Fig. 4: eine Draufsicht auf eine Abwandlung der Sieben-Segment-Anzeige aus Fig. 3.

### Detaillierte Beschreibung der Ausführungsbeispiele

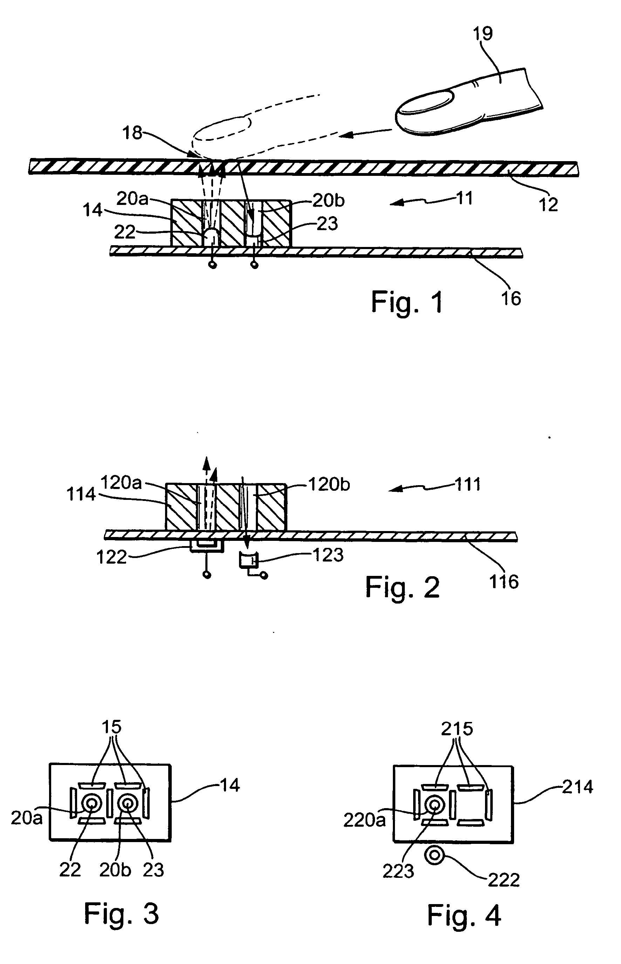

In Fig. 1 ist eine seitliche Ansicht einer erfindungsgemäßen Bedieneinrichtung 11 dargestellt. Unter einer Abdeckung 12 befindet sich eine Sieben-Segment-Anzeige 14, welche auf einer Leiterplatte 16 angeordnet ist. Die Sieben-Segment-Anzeige ist als eine Baueinheit ausgebildet und weist, wie aus der Draufsicht in Fig. 1 hervorgeht, sieben LED-Elemente 15 auf. Die Anordnung der LED-Elemente 15 bzw. der Sieben-Segment-Anzeige 14 entspricht dem, was an sich aus dem Stand der Technik bekannt ist.

Die Sieben-Segment-Anzeige 14 ist knapp unterhalb der Abdeckung 12 angeordnet. Sie könnte diese jedoch auch beinahe berühren oder einen größeren Abstand dazu aufweisen. Oberhalb der Sieben-Segment-Anzeige 14 ist an der Abdeckung 12 eine Berührfläche 18 ausgebildet. An diese Berührfläche 18 bzw. an dieser Stelle auf die Abdeckung 12 kann ein Finger 19 angelegt gelegt werden zur Bedienung der Bedieneinrichtung 11.

Die Sieben-Segment-Anzeige 14 bzw. ihr Gehäuse weist in jeweils einem Ring der LED-Elemente 15 einen Durchbruch 20a und 20b auf. Diese sind nach Art von zylindrischen Bohrungen ausgeführt. Sie können parallel zueinander verlaufen. Alternativ können sie zur besseren Führung eines Strahlenwegs derart schräg zueinander gestellt sein, dass ihre Verlängerungen in etwa in der Mitte der Berührfläche 18, auf welche der Finger 19 gelegt wird, zusammentreffen.

Im unteren Bereich des Durchbruchs 20a bzw. auf der Leiterplatte 16 aufliegend, ist links eine Lichtquelle 22 enthalten. In dem rechten Durchbruch 20b ist ein Lichtempfänger 23 enthalten. Die Lichtquelle 22 kann beispielsweise eine LED sein. Der Lichtempfänger 23 kann ein photosensitives Element sein, beispielsweise eine Photozelle oder ein Phototransistor. Gestrichelt dargestellt ist ein Strahlenweg von der Lichtquelle 22 weg. Das Licht wird an der Berührfläche 18 von dem angelegten Finger 19 reflektiert und zumindest ein Teil geht durch den rechten Durchbruch 20b zu dem Lichtempfänger 23. Sowohl Lichtquelle 22 als auch Lichtempfänger 23 sind mit einer nicht dargestellten Ansteuerung und Auswertung verbunden. So wird dieses Reflektieren und Auffangen am Lichtempfänger als Bedienung registriert.

Einer der großen Vorteile dieser Anordnung liegt darin, dass zum einen eine Betätigung direkt auf die Anzeige 14 möglich ist, also direkt auf ein dadurch dargestelltes bzw. angezeigtes Symbol. Des weiteren kann, wie aus Fig. 3 deutlich wird, der Zwischenraum bzw. Innenraum zwischen jeweils vier LED-Elementen 15 der Sieben-Segment-Anzeige 14 genutzt werden, um dort die Funktionsteile der Bedieneinrichtung 11, also Lichtquelle 22 und Lichtempfänger 23, unterzubringen. Schließlich liegt ein weiterer Vorteil darin, dass durch die kanalartigen Durchbrüche 20 in der Anzeige 14 bzw. in ihrem Gehäuse eine Abschirmung der Teil-Strahlwege zwischen Lichtquelle 22 und Lichtempfänger 23 und jeweils der Berührfläche 18 möglich ist. So können ansonsten notwendige Röhrchen, Kanäle oder sonstige Hilfsmittel zur Abschirmung zumindest teilweise vermieden werden.

In der Abwandlung der Bedieneinrichtung 111 in Fig. 2 ist angedeutet, inwiefern Lichtquelle 122 und/oder Lichtempfänger 123 nicht innerhalb des Gehäuses der Anzeige 114, sondern auch darunter angeordnet sein können. Dieses ist eine Ausführung, bei welcher Anzeige 114 und Lichtquelle 122 und Lichtempfänger 123 keine Baueinheit bilden. Die Bauteile 122 und 123 können nach oben arbeitend ausgebildet sein und an der Leiterplatte 126 angeordnet sowie kontaktiert sein. Alternativ können sie separat gehalten sein. Auch der Einsatz von Lichtleitern zu weiter entfernten oder zentralen Lichtmitteln ist möglich.

Der Vorteil einer Auslösung bzw. der Positionierung der Berührfläche direkt über der Anzeige 114 bleibt so auch ohne weiteren Aufwand voll erhalten. Ein weiterer möglicher Vorteil, nämlich Nutzung der Durchbrüche 120 als Kanal zur Abschirmung gegeneinander, ist nur durch weitere, die Durchbrüche 120 nach unten verlängernde Röhrchen oder dergleichen möglich. So können Streulichteinflüsse von der Lichtquelle 122 zum Lichtempfänger 123 verhindert werden. Solche zusätzlichen Abschirmmittel sind hier dadurch vermieden, dass die Lichtquelle 122 direkt unterhalb der Leiterplatte 126 angeordnet ist und nicht an dem Durchbruch 120a vorbeistrahlen kann.

In Fig. 3 ist eine Draufsicht aus die Anzeige 14 aus Fig. 1 dargestellt. Es ist deutlich zu erkennen, wie die Durchbrüche 20a und 20b innerhalb der Ringe von Segmenten 15 angeordnet sind. Darin sind jeweils Lichtquelle 22 und Lichtempfänger 23. angeordnet

In Fig. 4 ist eine Abwandlung der Anzeige 214 gemäß Fig. 1 in Draufsicht dargestellt. Die Anzeige 214 bzw. ihr Gehäuse weist in dem linken Ring von LED-Elementen 215 einen Durchbruch 220a auf. In ihm steckt, ähnlich wie in Fig. 1, im unteren Bereich ein Lichtempfänger 223.

Unter dem Gehäuse der Anzeige 214 ist der Lichtempfänger 223 angeordnet. Wie aus der Darstellung zu ersehen ist, wird für die Lichtquelle 222 nicht zwangsläufig eine Abschirmung ähnlich einem Kanal oder Durchbruch 20 gemäß den anderen Ausführungen benötigt. Dies liegt darin, dass es an sich als ausreichend angesehen wird, den Lichtempfänger 223 vor ungewünschtem Streulicht zu schützen. Dies erfolgt durch die Anzeige 214 bzw. durch den Durchbruch 220a. Für die Lichtquelle 222 ist dies nicht unbedingt notwendig. Es kann jedoch in weiterer Ausgestaltung vorgesehen sein, um einen außenliegenden Lichtempfänger 223 herum ein Röhrchen oder dergleichen vorzusehen, damit er kein Streulicht empfängt.

## Patentansprüche

1. Bedieneinrichtung (11, 111) zur Bedienung einer Vorrichtung, vorzugsweise eines Elektrogeräts wie beispielsweise ein Haushaltsgerät, mit einer Sieben-Segment-Anzeige (14, 114, 214) aus LED-Elementen (15, 115, 215) zur Anzeige eines Betriebszustandes oder einer Anweisung an einen Bediener und mit einem Berührschalter zur Bedienung, wobei der Berührschalter als Reflex-Lichtschranke ausgebildet ist mit einer Lichtquelle (22, 122, 222) und einem Lichtempfänger (23, 123, 223), **dadurch gekennzeichnet, dass** der Strahlenweg zwischen der Lichtquelle und dem Lichtempfänger mindestens einmal mitten durch die Sieben-Segment-Anzeige (14, 114, 214) geht, wobei der Strahlenweg durch die Sieben-Segment-Anzeige (14, 114, 214) in einem geschlossenen Kanal (20, 120, 220) verläuft.

2. Bedieneinrichtung nach Anspruch 1, **dadurch gekennzeichnet, dass** mindestens der Strahlenweg zum Lichtempfänger (23, 123, 223) hin durch die Sieben-Segment-Anzeige (14, 114, 214) läuft.

3. Bedieneinrichtung nach Anspruch 1 oder 2, **dadurch gekennzeichnet, dass** der Strahlenweg sowohl von der Lichtquelle (22, 122, 222) weg als auch zum Lichtempfänger (23, 123, 223) hin jeweils einmal durch die Sieben-Segment-Anzeige (14, 114, 214) geht, wobei vorzugsweise die beiden Strahlenwege getrennt sind

4. Bedieneinrichtung nach einem der vorhergehenden Ansprüche, **dadurch gekennzeichnet, dass** der Kanal (20, 120, 220) röhrenartig ist.

5. Bedieneinrichtung nach einem der vorhergehenden Ansprüche, **dadurch gekennzeichnet, dass** der Strahlenweg durch den Zwischenraum zwischen vier LED-Elementen (15, 215) in einem Teil der Sieben-Segment-Anzeige (14, 114, 214) läuft, wobei vorzugsweise jeweils durch beide Zwischenräume der Sieben-Segment-Anzeige der Strahlenweg einmal weg von der Lichtquelle (22, 122, 222) und einmal hin zum Lichtempfänger (23, 123, 223) verläuft.

6. Bedieneinrichtung nach einem der vorhergehenden Ansprüche, **dadurch gekennzeichnet, dass** die Sieben-Segment-Anzeige (14, 114, 214) eine Baueinheit ist, insbesondere ein einziges Bauteil.

7. Bedieneinrichtung nach Anspruch 6, **dadurch gekennzeichnet, dass** Lichtquelle (22, 122, 222) und/oder Lichtempfänger (23, 123, 223), vorzugsweise beide, in die Baueinheit, insbesondere das Bauteil, integriert sind.

8. Bedieneinrichtung nach einem der vorhergehenden Ansprüche, **dadurch gekennzeichnet, dass** die LED-Elemente (15, 215) und Lichtquelle (22, 122, 222) und Lichtempfänger (23, 123, 223) auf einer gemeinsamen Platine (16, 116) angeordnet sind.

9. Bedieneinrichtung nach einem der Ansprüche 1 bis 6, **dadurch gekennzeichnet, dass** Lichtquelle (122) und/oder Lichtempfänger (123) unterhalb der Sieben-Segment-Anzeige (114) und separat davon angeordnet sind.

## Claims

1. Operating device (11, 111) for operating an appliance, preferably an electrical appliance, such as for example a domestic appliance, having a seven-segment display (14, 114, 214) of LED elements (15, 115, 215) for displaying an operating state or an instruction to an operator and with a touch or contact switch for operating purposes, the touch switch being constructed as a reflected light barrier with a light source (22, 122, 222) and a light receiver (23, 123, 223), **characterized in that** the beam path between the light source and light receiver passes at least once centrally through the seven-segment display (14, 114, 214), with the beam path running through the seven-segment display (14, 114, 214) in a closed channel (20, 120, 220).

2. Operating device according to claim 1, **characterized in that** at least the beam path to the light receiver (23, 123, 223) passes through the seven-segment display (14, 114, 214).

3. Operating device according to claim 1 or 2, **characterized in that** the beam path both from the light source (22, 122, 222) and to the light receiver (23, 123, 223) in each case passes once through the seven-segment display (14, 114, 214), and preferably both beam paths are separated.

4. Operating device according to one of the preceding claims, **characterized in that** the channel (20, 120, 220) is in a tubular form.

5. Operating device according to one of the preceding claims, **characterized in that** the beam path passes through the gap between four LED elements (15, 215) in part of the seven-segment display (14, 114, 214) and preferably in each case through both gaps of the seven-segment display the beam path once passes away from light source (22, 122, 222) and once towards the light receiver (23, 123, 223).

6. Operating device according to one of the preceding claims, **characterized in that** the seven-segment display (14, 114, 214) is a unit, particularly a single component.

7. Operating device according to claim 6, **characterized in that** light source (22, 122, 222) and/or light receiver (23, 123, 223), preferably both, are integrated into the unit, particularly the component.

8. Operating device according to one of the preceding claims, **characterized in that** the LED elements (15, 215), as well as the light source (22, 122, 222) and light receiver (23, 123, 223) are placed on a common board (16, 116).

9. Operating device according to one of the claims 1 to 6, **characterized in that** the light source (122) and/or light receiver (123) are placed below and separately from the seven-segment display (114).

## Revendications

1. Dispositif de commande (11, 111) pour la commande d'un dispositif, de préférence d'un appareil électrique comme par exemple un appareil ménager, présentant un affichage sept segments (14, 114, 214) composé d'éléments DEL (15, 115, 215) pour l'affichage d'un état de service ou d'une instruction pour un utilisateur, et un commutateur à effleurement pour la commande, sachant que le commutateur à effleurement est réalisé comme dispositif photoélectrique avec une source de lumière (22, 122, 222) et un récepteur optique (23, 123, 223), **caractérisé en ce que** la trajectoire du rayon entre la source lumineuse et le récepteur optique passe au moins une fois au travers de l'affichage sept segments (14, 114, 214); sachant que la trajectoire du rayon passe à travers l'affichage sept segments (14, 114, 214) dans un conduit (20, 120, 220) fermé.

2. Dispositif de commande d'après la revendication 1, **caractérisé en ce qu'**au moins la trajectoire du rayon vers le récepteur optique (23, 123, 223) passe à travers l'affichage sept segments (14, 114, 214).

3. Dispositif de commande d'après la revendication 1 ou 2, **caractérisé en ce que** les trajectoires de rayon, non seulement celle à partir de la source de lumière (22, 122, 222), mais aussi celle vers le récepteur optique (23, 123, 223), passent respectivement une fois à travers l'affichage sept segments (14, 114, 214), sachant que de préférence les deux trajectoires de rayon sont séparées.

4. Dispositif de commande d'après une des revendications précédentes, **caractérisé en ce que** le conduit (20, 120, 220) présente une forme tubulaire.

5. Dispositif de commande d'après une des revendications précédentes, **caractérisé en ce que** la trajectoire de rayon passe à travers l'espace libre entre quatre éléments DEL (15, 215) dans une partie de l'affichage sept segments (14, 14, 214), sachant que la trajectoire du rayon s'étend de préférence respectivement à travers les deux espaces libres de l'affichage sept segments, une fois à partir de la source de lumière (22, 122, 222) et une fois vers le récepteur optique (23, 123, 223).

6. Dispositif de commande d'après une des revendications précédentes, **caractérisé en ce que** l'affichage sept segments (14, 114, 214) est une unité de construction, de préférence un seul composant.

7. Dispositif de commande d'après la revendication 6, **caractérisé en ce que** la source de lumière (22, 122, 222) et/ou le récepteur optique (23, 123, 223), de préférence les deux, sont intégrés dans une unité de construction, notamment dans le composant.

8. Dispositif de commande d'après une des revendications précédentes, **caractérisé en ce que** les éléments DEL (15, 215), la source de lumière (22, 122, 222) et le récepteur optique (23, 123, 223) sont disposés conjointement sur une carte à circuit imprimé (16, 116).

9. Dispositif de commande d'après une des revendications de 1 à 6, **caractérisé en ce que** la source de lumière (122) et/ou le récepteur optique (123) sont disposés au-dessous de l'affichage sept segments (114) et de manière séparée de celui-ci.
